# EUROPEAN PATENT APPLICATION

(11) **EP 4 556 785 A1**
(43) Date of publication of application: **21.05.2025**
(21) Application number: 24171062.3
(22) Date of filing: 18.04.2024
(51) Int. Cl.: F21S 4/24, F21V 23/00, H05K 1/18, F21Y 103/10, F21Y 107/70, F21Y 115/10

(54) **FLEXIBLE LED STRIP WITH A NOVEL FPCB STRUCTURE**

(30) Priority: 14.11.2023 CN 202323071912 U
(71) Applicant: Shenzhen Clear Lighting Co., Ltd., Shenzhen, Guangdong 518000 (CN); Huizhou Clear Lighting Co., Ltd., Huiyang District Huizhou, Guangdong 516000 (CN)
(72) Inventor: Shang, Chenghuo, Cambridge (GB); Huang, Minfei, Cambridge (GB); Chen, Xianqi, Cambridge (GB); Tang, Yuanbiao, Cambridge (GB); Liu, Changgui, Cambridge (GB)
(74) Representative: Horak, Michael

(57) **Abstract**

A flexible LED light strip with a novel FPCB structure is disclosed. The flexible LED light strip with a novel FPCB structure at least comprises: a PCB light strip (1) assembled from a plurality of planar FPCB lamp boards (11), each said planar FPCB lamp board (11) is soldered with a conductive connection plate (2) which extends beyond both sides of said planar FPCB lamp board (11), at least one metal wire (3) is soldered on the same side of a plurality of conductive connection plates (2) respectively, and a plurality of LED light sources are disposed on at least one side of each said planar FPCB lamp board (11); an insulating layer (5) wrapped around said PCB light strip (1). Implementing this invention allows for installation and use with bending in different directions, and enables automated production, which can improve production efficiency.

## Description

### FIELD OF THE INVENTION

Embodiments of the present disclosure relate to the field of lighting technology, and more particularly to a flexible LED light strip with a novel FPCB (Flexible Printed Circuit Board) structure.

### DISCUSSION OF THE RELATED ART

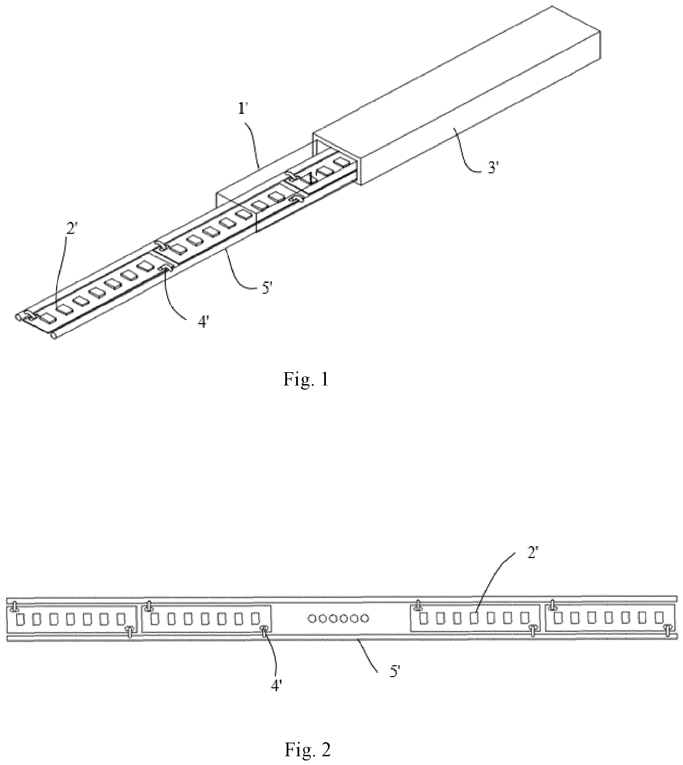

As shown in Figure 1, a conventional LED flexible light strip is presented, which includes a core wire 1'. A strip-shaped FPCB lamp board 2' is disposed within the core wire 1'. An outer layer of soft elastic plastic or silicone insulation 3' is wrapped around the core wire 1 ', thus forming a complete LED flexible light strip.

As depicted in Figure 2, a structural schematic of the strip-shaped FPCB lamp board 2' from Figure 1 is illustrated. It comprises multiple individual FPCB lamp boards. Each single-section FPCB lamp board is designed with solder points, LED beads, or other electronic components. These are connected in parallel by several single-section FPCB lamp boards, metal jumpers 4', and metal wires 5' to form the strip-shaped FPCB lamp board. This type of strip-shaped FPCB lamp board requires the metal jumpers 4' to be soldered onto each section of the FPCB lamp boards to establish an electrical circuit.

However, the current method of forming a strip-shaped FPCB lamp board by connecting multiple sections of FPCB lamp boards, metal jumpers, and metal leads in parallel involves soldering several metal jumpers 4' onto the long metal wires 5'. This process generally requires manual intervention for parallel soldering and presents the following disadvantages:

It cannot achieve automated production, resulting in lower production efficiency.

The use of multiple metal leads (such as 3, 4, 5, etc.) becomes complex.

Manual soldering is prone to form false solder connections, and manual operation has certain safety risks.

### SUMMARY

The technical problem to be solved by the present invention is to provide a flexible LED light strip with a novel FPCB structure that allows for installation and use in different directions, and can achieve automated production to enhance production efficiency.

To solve above-mentioned technical problem, one aspect of the present invention provides a flexible LED light strip with a novel FPCB structure which at least comprises: a PCB light strip assembled from a plurality of planar FPCB lamp boards, each said planar FPCB lamp board is soldered with a conductive connection plate which extends beyond both sides of said planar FPCB lamp board, at least one metal wire is soldered on the same side of a plurality of conductive connection plates respectively, and a plurality of LED light sources are disposed on at least one side of each said planar FPCB lamp board; and an insulating layer wrapped around said PCB light strip.

Advantageously, each said conductive connection plate is provided with bent lines at both ends to enable bending, and one or more spaced wire soldering areas are defined on one side or both sides of said conductive connection plate.

Advantageously, said metal wire is a flexible or a retractable wire, and said insulating layer is made from silicone or plastic materials.

Another aspect of the present invention provides a flexible LED light strip with a novel FPCB structure which at least comprises: a PCB light strip assembled from a plurality of L-shaped FPCB lamp boards, each said L-shaped FPCB lamp board is soldered with a conductive connection plate which extends beyond both sides of said L-shaped FPCB lamp board, at least one metal wire is soldered on the same side of a plurality of conductive connection plates respectively, and a plurality of LED light sources are disposed on at least one side of each said L-shaped FPCB lamp board; and an insulating layer wrapped around said PCB light strip.

Advantageously, each said conductive connection plate is provided with bent lines at both ends to enable bending, and one or more spaced wire soldering areas are defined on one side or both sides of said conductive connection plate.

Advantageously, said metal wire is a flexible or a retractable wire, and said insulating layer is made from silicone or plastic materials.

Advantageously, said L-shaped FPCB lamp board comprises a first board body, and a plurality of second board bodies extending from said first board body and perpendicular to said first board body, said LED light sources are disposed on at least one side of said second board bodies.

Performing the present invention will bring out the following beneficial effects:

Due to the adoption of a conductive connection plate structure, the invention can achieve automated production and support more complex circuit designs. This significantly improves production efficiency, reduces labor costs, and minimizes safety risks during production.

In this invention, the PCB light strip is designed with a segmented structure, and the metal leads are made from retractable wires, allowing the LED flexible light strip provided by the invention to bend in different directions when in use. Moreover, with the novel FPCB lamp board employed in this invention, the light strip maintains its flexibility when bent in various directions.

### BRIEF DESCRIPTION OF THE DRAWINGS

In order to more clearly illustrate the embodiments of the present invention or the technical solutions in the prior art, the drawings used in the embodiments or the description of the prior art will be briefly described below Obviously, the drawings in the following description are only certain embodiments of the present invention, and other drawings can be obtained from those skilled in the art without any creative work.
Figure 1 illustrates the structure of a conventional LED flexible light strip.
Figure 2 shows the structural schematic of the elongated FPCB lamp board from Figure 1.
Figure 3 presents the structural schematic of the first embodiment of a flexible LED light strip with a novel FPCB structure provided by the present invention.
Figure 4 depicts the assembled structure of the PCB light strip from Figure 3.
Figure 5 is the cross-sectional view along A-A from Figure 4.
Figure 6 demonstrates the connection principle schematic from Figure 4.
Figure 7 illustrates the structural schematic of the L-shaped FPCB lamp board from Figure 4.
Figure 8 shows the structural schematic of the conductive connection plate from Figure 4.
Figure 9 displays the structure after connecting the conductive connection plate and the L-shaped FPCB lamp board.
Figure 10 exhibits the assembled structure of the PCB light strip for the second embodiment of a flexible LED light strip with a novel FPCB structure provided by the present invention.
Figure 11 shows the structure after connecting the conductive connection plate and the L-shaped FPCB lamp board from Figure 10.
Figure 12 illustrates the structural schematic of the planar FPCB lamp board from Figure 11.
Figure 13 presents the connection principle schematic from Figure 11.
Figure 14 is a schematic illustrating the bending directions of the present invention.

### DETAILED DESCRIPTION OF THE EMBODIMENTS

The technical solutions in the embodiments of the present invention are clearly and completely described below with reference to the accompanying drawings in the embodiments of the present invention. Apparently, the described embodiments are merely a part of but not all embodiments of the present invention. All other embodiments obtained by a person of ordinary skilled in the art based on the embodiments of the present invention without creative efforts shall fall within the protection scope of the present invention.

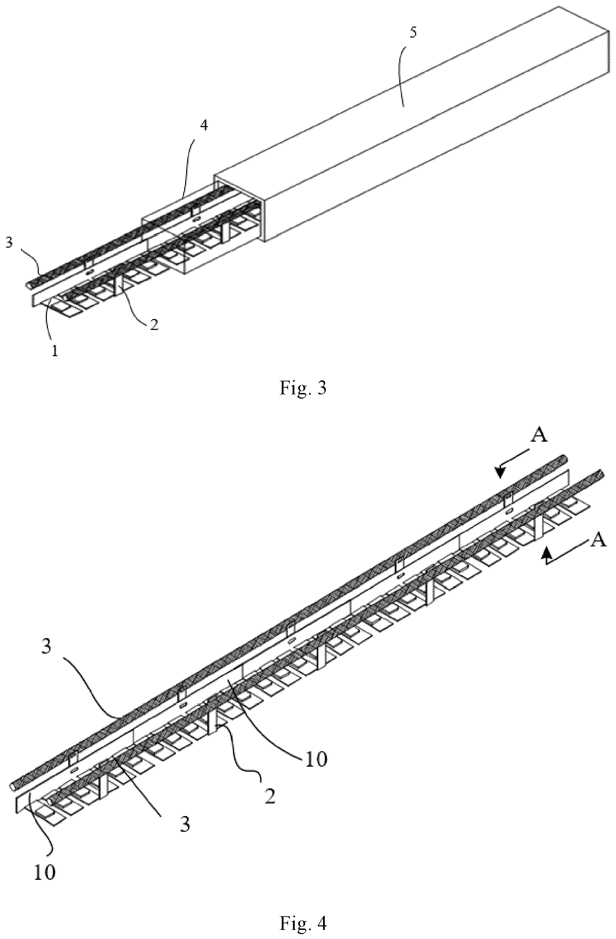

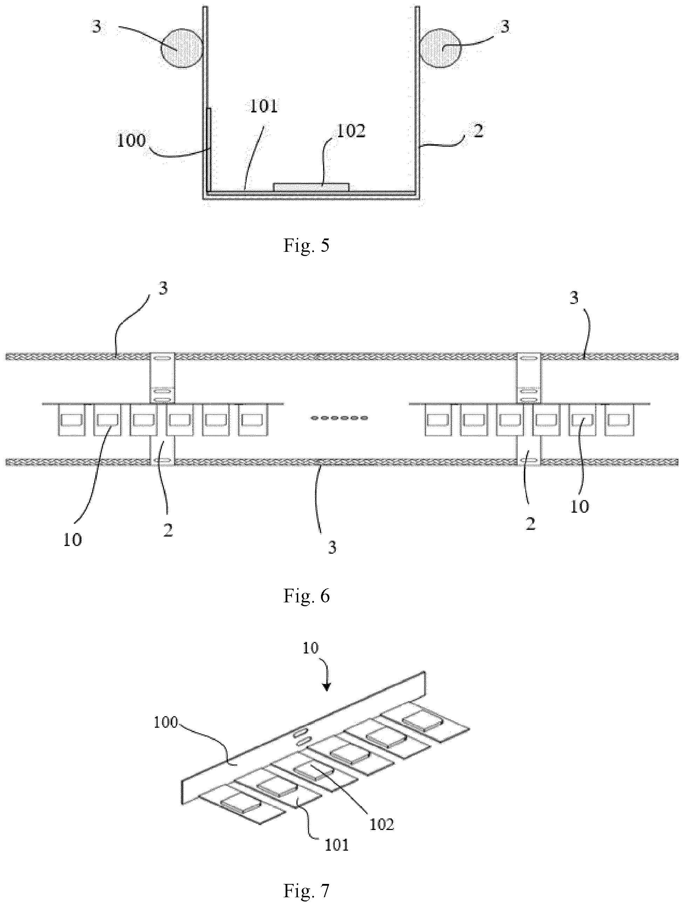

As shown in Figure 3, a schematic representation of the structure of the first embodiment of a flexible LED light strip provided by this invention is depicted. In conjunction with Figures 4 through 9, in this embodiment, the flexible LED light strip comprises at least:

PCB light strip 1, assembled from a plurality of L-shaped FPCB lamp boards 11. Each L-shaped FPCB lamp board 10 is soldered with a conductive connection plate 2, which extends beyond both sides of the L-shaped FPCB lamp board 10. On the same side of multiple conductive connection plates 2, there is at least one metal wire 3 soldered respectively. Each L-shaped FPCB lamp board 10 has a plurality of LED light sources on at least one side, in some cases, the number of metal wires 3 could be, for example, 2, 3, 4, 5, or other quantities. The conductive connection plate 2 may be made of iron, copper, aluminum, brass, or alloys thereof.
a protective layer 4 encasing the PCB light strip 1.
an insulating layer 5 wrapped around the protective layer 4.

It should be understood that, in practical applications, the protective layer 4 can be omitted, and the insulating layer 5 can be directly wrapped around the PCB light strip 1.

More specifically, both ends of each conductive connection plate 2 are bent, for instance, into a U-shape, and the dashed line shown in the figure indicates the bending position. One or more spaced wire soldering areas 21 are provided on one or both sides of the conductive connection plate 2. In a specific example, the circuit connection board 6 can be fabricated using FPCB board technology or other manufacturing processes.

Similarly, the metal wires 3 may be made of iron, copper, aluminum, brass, or alloys thereof, and they can further be configured as flexible or retractable wires. The insulating layer 5 is made from silicone or plastic materials. Specifically, it could be made of PVC, silicone, PU, or other soft plastic materials. In practical examples, the insulating layer 5 might be transparent, white, black, or colored plastic material with light-transmitting or light-blocking properties.

More specifically, the L-shaped FPCB lamp board 10 comprises a first board body 100, and a plurality of second board bodies 101 extending from the first board body 100 and perpendicular to the first board body 100. LED light sources 102 are disposed on at least one side of the second board bodies 101.

In the present invention, the optimal structure involves placing the PCB light strip at the symmetrical center of the insulating layer 5. The cross-section of the light strip formed by the insulating layer 5 could be circular, oval, rectangular, or another polygonal shape.

It is understood that in this embodiment, the circuit connection board 6 is connected in parallel to the main metal wire after being soldered to the main circuit board, which can perform the function of diverting and guiding the circuit current. This allows the main wire current to be transferred to the retractable metal wires, enabling more complex circuit designs on the FPCB lamp panel. At the same time, it allows for the parallel use of multiple wires. As a result, it can achieve automated production and enhance production efficiency.

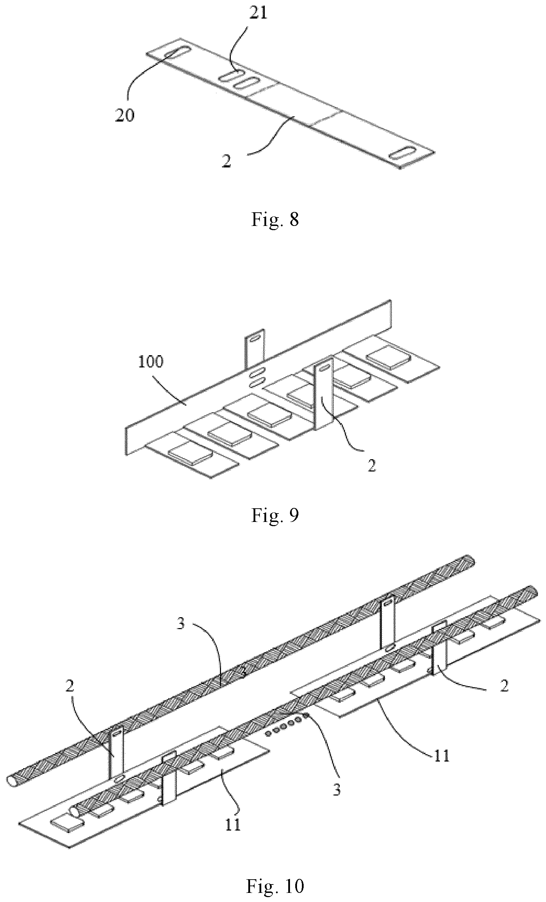

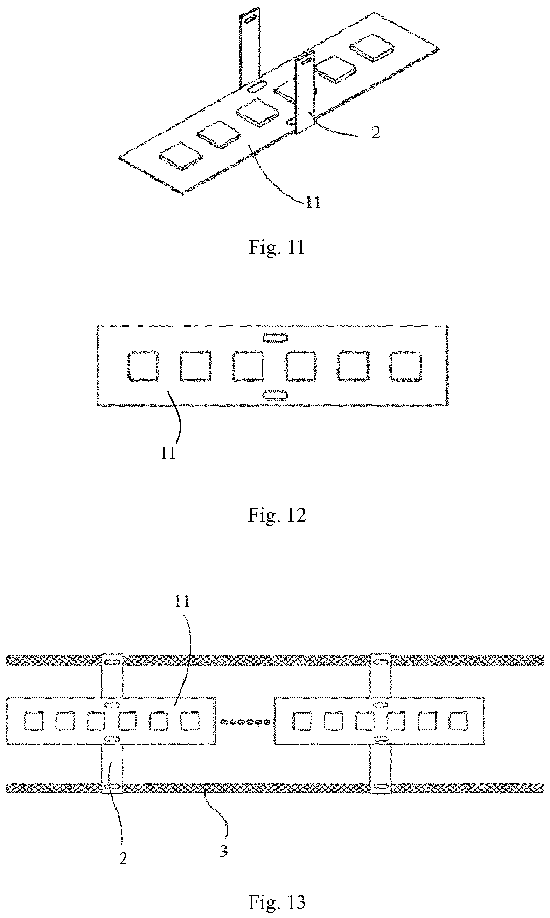

As shown in Figure 10, a schematic representation of the structure of the second embodiment of a flexible LED light strip provided by this invention is depicted. In conjunction with Figures 11 through 13, in the second embodiment, the flexible LED light strip comprises at least:

PCB light strip 1, assembled from a plurality of planar FPCB lamp boards 11. Each planar FPCB lamp board 10 is soldered with a conductive connection plate 2, which extends beyond both sides of the planar FPCB lamp board 10. On the same side of a plurality of conductive connection plates 2, there is at least one metal wire 3 soldered respectively. Each planar FPCB lamp board 10 has a plurality of LED light sources on at least one side.

A protective layer 4 encasing the PCB light strip 1.

An insulating layer 5 wrapped around the protective layer 4.

It should be understood that, in practical applications, the protective layer 4 can be omitted, and the insulating layer 5 can be directly wrapped around the PCB light strip 1.

More specifically, both ends of each conductive connection plate 2 are bent, for instance, into a U-shape. One or more spaced wire soldering areas 20 are provided on one or both sides of the conductive connection plate 2.

Preferably, the metal wires 3 can be made of iron, copper, aluminum, brass, or alloys thereof. They can further be configured as flexible or retractable wires.

The insulating layer 5 is made from silicone or plastic materials. Specifically, it could be made of PVC, silicone, PU, or other soft plastic materials. In practical examples, the insulating layer 5 might be transparent, white, black, or colored plastic material with light-transmitting or light-blocking properties.

In the present invention, the optimal structure involves placing the PCB light strip at the symmetrical center of the insulating layer 5. The cross-section of the light strip formed by the insulating layer 5 could be circular, oval, rectangular, or another polygonal shape.

For more details, refer to and combine the previous description of the first embodiment, which will not be repeated here.

It is understood that in this invention, the metal wires 3 may be woven from a plurality of wires, providing retractable properties. The metal wires 3 can also adopt retractable structures such as spring-like wires, wavy wires, coiled wires, etc.

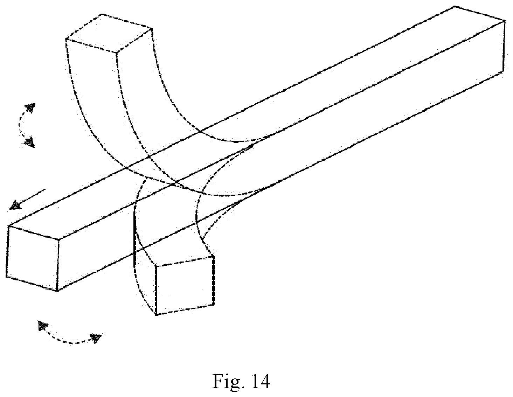

As shown in Figure 14, a schematic of the bending directions of this utility model is illustrated. It is understood that, due to the segmented structure of the PCB light strip and the use of retractable structure for the metal wires in this embodiment, the LED flexible light strip provided by the present invention can achieve bending in different directions when in use.

Implementing the embodiments of the present invention has the following beneficial effects:

Due to the adoption of a conductive connection plate structure, the invention can achieve automated production and support more complex circuit designs. This significantly improves production efficiency, reduces labor costs, and minimizes safety risks during production.

In this invention, the PCB light strip is designed with a segmented structure, and the metal leads are made from retractable wires, allowing the LED flexible light strip provided by the invention to bend in different directions when in use. Moreover, with the novel FPCB lamp board employed in this invention, the light strip maintains its flexibility when bent in various directions.

It is believed that the present embodiments and their advantages will be understood from the foregoing description, and it will be apparent that various changes may be made thereto without departing from the spirit and scope of the invention or sacrificing all of its material advantages, the examples hereinbefore described merely being preferred or exemplary embodiments of the invention.

## Claims

1. A flexible LED light strip with a novel FPCB structure, at least comprises:
a PCB light strip (1) assembled from a plurality of planar FPCB lamp boards (11), each said planar FPCB lamp board (11) is soldered with a conductive connection plate (2) which extends beyond both sides of said planar FPCB lamp board (11), at least one metal wire (3) is soldered on the same side of a plurality of conductive connection plates (2) respectively, and a plurality of LED light sources are disposed on at least one side of each said planar FPCB lamp board (11);
an insulating layer (5) wrapped around said PCB light strip (1).

2. The flexible LED light strip as claimed in claim 1, wherein each said conductive connection plate (2) is provided with bent lines at both ends to enable bending, and one or more spaced wire soldering areas (21) are defined on one side or both sides of said conductive connection plate (2).

3. The flexible LED light strip structure as claimed in claim 2, wherein said metal wire (3) is a flexible or a retractable wire, and said insulating layer (5) is made from silicone or plastic materials.

4. A flexible LED light strip with a novel FPCB structure, at least comprises:
a PCB light strip (1) assembled from a plurality of L-shaped FPCB lamp boards (10), each said L-shaped FPCB lamp board (10) is soldered with a conductive connection plate (2) which extends beyond both sides of said L-shaped FPCB lamp board (10), at least one metal wire (3) is soldered on the same side of a plurality of conductive connection plates (2) respectively, and a plurality of LED light sources are disposed on at least one side of each said L-shaped FPCB lamp board (10);
an insulating layer (5) wrapped around said PCB light strip (1).

5. The flexible LED light strip as claimed in claim 4, wherein each said conductive connection plate (2) is provided with bent lines at both ends to enable bending, and one or more spaced wire soldering areas (21) are defined on one side or both sides of said conductive connection plate (2).

6. The flexible LED light strip as claimed in claim 5, wherein said metal wire (3) is a flexible or a retractable wire, and said insulating layer (5) is made from silicone or plastic materials.

7. The flexible LED light strip as claimed in claim 4, wherein said L-shaped FPCB lamp board (10) comprises a first board body (100), and a plurality of second board bodies (101) extending from said first board body (100) and perpendicular to said first board body (100), LED light sources (102) are disposed on at least one side of said second board bodies (101) .

## Amended claims

### Amended claims in accordance with Rule 137(2) EPC.

1. A flexible LED light strip with a novel FPCB structure, at least comprises:
a PCB light strip (1), at least one metal wire (3), a plurality of LED light sources, and an insulating layer (5); **characterized in that**:
the PCB light strip (1) is assembled from a plurality of L-shaped FPCB lamp boards (10), each said L-shaped FPCB lamp board (10) is soldered with a conductive connection plate (2) which extends beyond both sides of said L-shaped FPCB lamp board (10), the at least one metal wire (3) is soldered on the same side of a plurality of conductive connection plates (2) respectively, and the plurality of LED light sources are disposed on at least one side of each said L-shaped FPCB lamp board (10); and
the insulating layer (5) is wrapped around said PCB light strip (1).

2. The flexible LED light strip as claimed in claim 1, wherein each said conductive connection plate (2) is provided with bent lines at both ends to enable bending, and one or more spaced wire soldering areas (21) are defined on one side or both sides of said conductive connection plate (2).

3. The flexible LED light strip as claimed in claim 2, wherein said metal wire (3) is a flexible or a retractable wire, and said insulating layer (5) is made from silicone or plastic materials.

4. The flexible LED light strip as claimed in claim 1, wherein said L-shaped FPCB lamp board (10) comprises a first board body (100), and a plurality of second board bodies (101) extending from said first board body (100) and perpendicular to said first board body (100), LED light sources (102) are disposed on at least one side of said second board bodies (101).
